# EUROPEAN PATENT APPLICATION

(11) **EP 4 675 660 A1**
(43) Date of publication of application: **07.01.2026**
(21) Application number: 25187248.7
(22) Date of filing: 03.07.2025
(51) Int. Cl.: H01H 47/00, H01H 1/20

(54) **POWER SWITCHING DEVICE WITH SELF DIAGNOSTIC CAPABILITY**

(30) Priority: 05.07.2024 US 202418764437
(71) Applicant: TE Connectivity Solutions GmbH, 8200 Schaffhausen (CH)
(72) Inventor: PRIEST, Marcus, Carpinteria, 93013 (US)
(74) Representative: Ashton, Gareth Mark

(57) **Abstract**

A power switch (100) for use in an electrical system, a power switch electrical control system and a method of monitoring the operation of an electrical control system of a power switch. The power switch includes a housing (102). A controller is positioned in the housing. At least one sensor is positioned in the housing (102) and is provided in electrical communication with the controller. The at least one sensor collects data in real time from inside the housing. The collected data is sent to the controller in real time and analyzed to determine if the operation of the power switch (100) is within designated safety ranges.

## Description

The invention relates generally to power switching devices for electric circuits, and more particularly to contactor assemblies.

Power switching devices, such as electromagnetic relays, contactors and/or solid-state relays are often used in electronic systems. However, the power switching devices are not able to self-test critical parameters relating to their health or proper operation, which can result in the failure or improper operation of the devices and the system.

It would, therefore, be beneficial to provide a power switching device that can self-test critical parameters relating to its health or proper operation. In particular, it would be beneficial to provide a power switched device that can measure its own performance state, providing the measured data back to a system controller for the purpose of system management and reliability.

The solution is provided by a power switch for use in an electrical system. The power switch includes a housing. A controller is positioned in the housing. At least one sensor is positioned in the housing and is provided in electrical communication with the controller. The at least one sensor collects data in real time from inside the housing. The collected data is sent to the controller in real time and analyzed to determine if the operation of the power switch is within designated safety ranges. If the collected data is outside of the designated safety ranges, the further operation of the power switch may be prevented, for example a coil current maintaining the power switch in a closed state may be stopped to open the power switch.

The invention will now be described by way of example with reference to the accompanying drawings in which:
FIG. 1 is a view of an illustrative power switch or contactor which incorporates a controller for self-testing and self-monitoring.
FIG. 2 is a cross-sectional view of the contactor taken along line 2-2 of FIG. 1.
FIG. 3 is a block diagram of an illustrative monitoring system of the present invention.
FIG. 4 is a flow chart of a method of controlling the operation of the power switch or contactor and the electrical system.

An embodiment is directed to a power switch for use in an electrical system. The power switch includes a housing. A controller is positioned in the housing. At least one sensor is positioned in the housing and is provided in electrical communication with the controller. The at least one sensor collects data in real time from inside the housing. The collected data is sent to the controller in real time and analyzed to determine if the operation of the power switch is within designated safety ranges. The housing may comprise at least one aperture through which contacts of the power switch pass for connection to external circuits. The contacts may be fixed contacts and the power switch may comprise a movable contact such as a movable contact bridge for contacting the fixed contacts.

An embodiment is directed to a power switch electrical control system which includes a controller positioned inside a housing of a power switch. One or more sensors are positioned inside the housing of the power switch. The one or more sensors are provided in electrical communication with the controller. The one or more sensors collect data in real time from inside the housing of the power switch and transmit the collected data to the controller. The controller compares the collected data and stored data to determine if the collected data is within designated safety ranges. The controller may terminate the operation of the power switch if the collected data is not within the designated safety ranges.

An embodiment is directed to a method of monitoring the operation of an electrical control system of a power switch. The method includes: transmitting real time collected data back from sensors located internal to a housing of a power switch internal controller located internal to the housing of the power switch; and comparing, in real time, the collected data to data stored in the controller internal controller to determine if the collected data is within the designated safety ranges. If the collected data is outside of the designated safety ranges, the controller may terminate the operation of the power switch. If the collected data is within the designated safety ranges, the controller allows the operation of the power switch to continue.

Provided is a power switching device or contactor assembly 100 and a method of controlling the operation of a power switching device or contactor assembly 100. Embodiments of the present disclosure, for example, in comparison to concepts failing to include one or more features disclosed herein, provide for a power switching device or contractor which can self-test critical parameters relating to its health or proper operation, and which can measure its own performance state, providing the measured data back to a system controller for the purpose of system management and reliability.

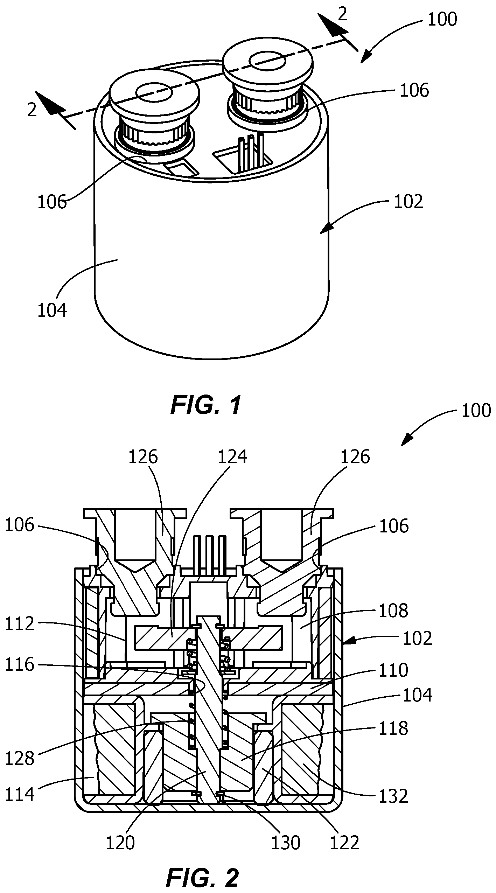

An illustrative embodiment of a contactor assembly 100 is shown in FIGS. 1 and 2. While the illustrative embodiment illustrates the contactor assembly 100, different contactor assemblies and power switched may be used.

The contactor assembly 100 includes housing 102 having a housing wall 104 including at least one aperture 106 extending through the housing wall 104. The housing wall 104 further defines a cavity 108. A partition 110 is positioned in the cavity 108 and defines at least two regions 112, 114 within the cavity 108. The partition 110 further includes a partition aperture 116 positioned to allow communication between the at least two regions 112, 114.

The contactor assembly 100 further includes an armature 118 positioned within the cavity 108. The armature 118 further includes a central bore 120 for example a central shaft. The armature 118 is slidably positioned via a bearing 122, allowing the central bore 120 to slidably extend through the partition aperture 116, for example along a guide, into both of the at least two regions 112, 114. A movable electrical contact bridge 124 is attached to the central bore 120 and configured to be in selective communication with fixed electrical contacts 126 such that the central bore 120 may be selectively positioned to allow communication such as electrical communication between the electrical contact bridge 124 and the fixed electrical contacts 126. The fixed electrical contacts 126 may be further configured to selectively communicate with an external circuit (not shown) via the at least one aperture 106.

The armature 118 further includes an armature spring 128 positioned in the region 114. The armature spring 128 is attached to both the partition 110 and armature 118. The armature spring 128 is configured to apply an armature spring force to the armature 128. The armature spring force may cause the armature 118 to slidably at least partially retract through the partition aperture 116 which may selectively position the armature 118 such that the electrical contact bridge 124 and fixed electrical contacts 126 will not be in communication. A retaining clip 130 is added to an end of the central bore 120 to transfer an impact between the armature 118 and the electrical contact bridge 124 during movement of the armature 118, in order to allow for an increased parting force and velocity.

The contactor assembly 100 further includes an electrically conductive coil 132 positioned within the housing 102 and configured to apply a magnetic force to the armature 118 in response to a coil current within the electrically conductive coil 132. The magnetic force may be in opposition to the armature spring force acting on the armature 118. The magnetic force may cause the armature 118 to slidably at least partially extend through the partition aperture 116, which may selectively position the armature 118 such that the electrical contact bridge 124 and fixed electrical contacts 126 will be in communication. The rapidity of the mechanical movement of the armature 118, in response to the magnetic force, determines how quickly the contactor assembly 100 will respond to the application of the coil current.

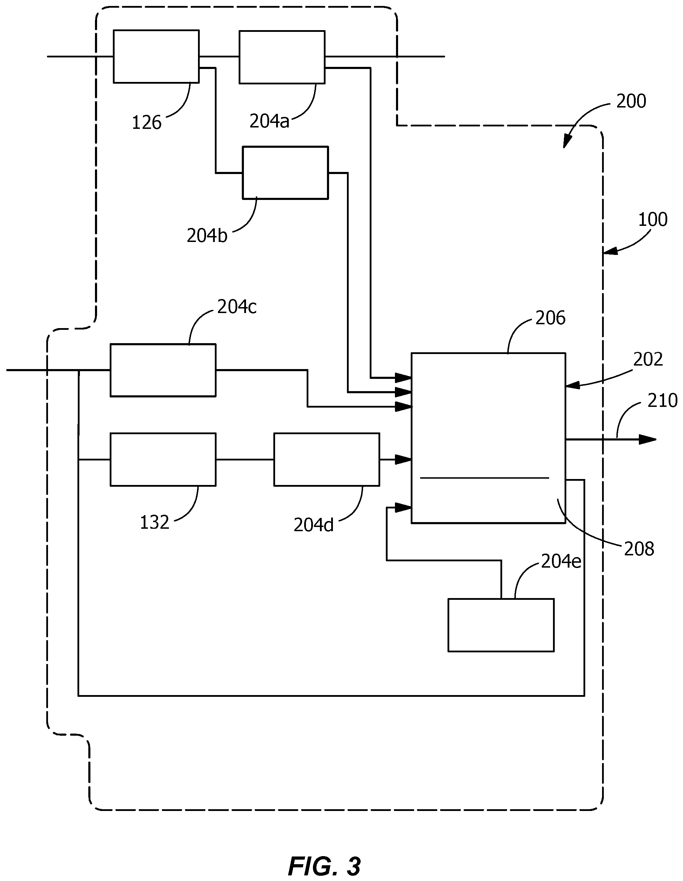

FIG. 3 is a block diagram of a representative power switch electrical control system 200 of the illustrative contactor assembly 100. While the electrical control system 200 is shown in relation to the contactor assembly 100, the electrical control system 200 may be used with other types of contactors and power switches.

The electrical control system include an internal controller 202 which is positioned inside of the housing 102 of the contactor assembly 100. The internal controller 202 may include a microcontroller 206 and a memory 208. In general, the internal controller 202 monitors status data, compiles the data, transmits the data via a communications bus, and intercedes in the operation of the contact assembly 100 for safety purposes, as will be more fully described.

As shown in FIG. 3, one or more sensors 204 are provided to monitor and collect data in real time relative to different components of the contactor assembly 100. The sensors 204 may be of different varieties to monitor different parameters of different components. For example, sensors 204 may be provided to monitor and collect data in real time regarding: i) the state of contact or junction (i.e., conduction or not); ii)state of the armature; iii) main contact or junction current; iv) contact voltage drop of forward junction drop; v) voltage on input as wall as output; vi) coil current or current voltage (and thereby, coil resistance and temperature); vii) main contact or junction temperature; viii) device motion; and/or ix) internal atmosphere (sealed device with internal gas, vacuum, etc.). Sensors 204 may also be provided to monitor and collect data for other parameters. In the illustrative embodiment shown, a load sensor 204a, a contact sensor 204b, a contactor coil current sensor 204c, a contactor coil voltage sensor 204d, and an ambient temperature sensor 204e are shown. However, different sensors may be used.

The internal controller 202 receives the data collected from the one or more sensors 204. The collected data is compiled and compared to stored data provided in the memory 208 of the internal controller 202. The stored data is data which indicates the acceptable ranges for the contactor assembly 100 to be operated safely. The collected data may also be transmitted via a communications bus 210 to outside of the housing 102 of the contactor assembly 100.

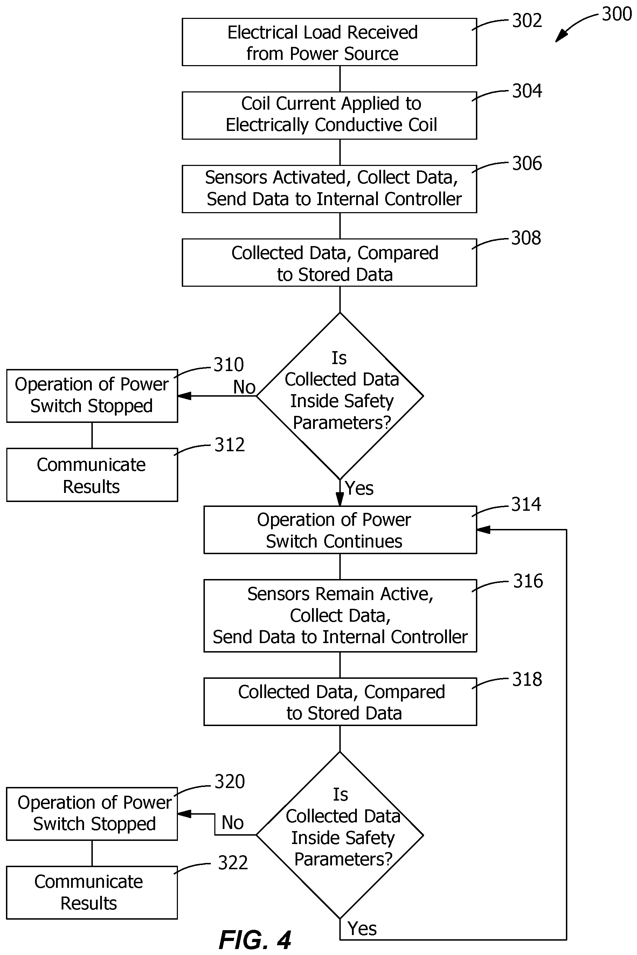

Referring to the flow chart of FIG. 4, an illustration embodiment of the operation 300 of the contactor assembly 100 having an internal controller 202 is shown. Initially, the contactor assembly 100 or power switch receives an electrical load from a power source, as represented by 302. In the illustrative embodiment, a coil current is applied to the electrically conductive coil 132, causing the central bore 120 of the armature 118 and the electrical contact bridge 124 to move toward the fixed electrical contacts 126, as represented by 304. As this occurs, the sensors 204 are activated and transmit real time collected data back to the internal controller 202 , as represented by 306. Additionally, or alternatively, data collection may begin any time the source or coil bias power is active.

The internal controller 202 compares, in real time, the collected data to the stored data to determine if the operation of the contactor assembly 100 or power switch is within the designated safety ranges, as represented by 308. If the collected data is outside of the designated safety ranges, the further operation of the contactor assembly 100 or power switch may be prevented and the coil current applied to the electrically conductive coil 132 may be stopped, preventing the electrical contact bridge 124 from electrically engaging the fixed electrical contacts 126, as represented by 310. Any stoppage and/or relative data are communicated via the communication bus outside of the contactor assembly 100 or power switch, as represented by 312. If the collected data is within the designated safety ranges, the further operation of the contactor assembly 100 or power switch is allowed to continue, allowing the electrical contact bridge 124 to electrically engage the fixed electrical contacts 126, as represented by 314.

With the contactor assembly 100 supplied with source voltage or coil bias power or with the power switch operating, i.e., the electrical contact bridge 124 in electrical engagement with the fixed electrical contacts 126, the sensors 204 remain active and continue to transmit real time collected data back to the internal controller 202, as represented by 316. The internal controller 202 compares, in real time, the collected data to the stored data to determine if the operation of the contactor assembly 100 or power switch is within the designated safety ranges, as represented by 318. If any of the collected data is outside of the designated safety ranges, the further operation of the contactor assembly 100 or power switch may be stopped and the coil current applied to the electrically conductive coil 132 is stopped, causing the electrical contact bridge 124 to be removed from the fixed electrical contacts 126 preventing current from flowing across the electrical contact bridge 124, as represented by 320. The stoppage and relative data are communicated via the communication bus outside of the contactor assembly 100 or power switch, as represented by 322. If all of the collected data is within the designated safety ranges, the further operation of the contactor assembly 100 or power switch is allowed to continue, as represented by 314.

## Claims

1. A power switch (100) for use in an electrical system, the power switch comprising
a housing (102);
a controller (202) positioned in the housing;
at least one sensor (204) positioned in the housing and provided in electrical communication with the controller (202), the at least one sensor (204) collects data in real time from inside the housing;
wherein the collected data is sent to the controller (202) in real time and analyzed to determine if the operation of the power switch (100) is within designated safety ranges.

2. The power switch (100) as recited in claim 1, wherein the controller (202) is a microcontroller.

3. The power switch (100) as recited in claim 1 or 2, wherein the controller (202) includes a memory.

4. The power switch (100) as recited in claim 1, 2 or 3, wherein a communications bus (210) extends from the controller (202) to outside of the housing (102) of the power switch.

5. The power switch (100) as recited in any preceding claim, wherein the power switch is a contactor (100).

6. The power switch (100) as recited in claim 5, wherein the contactor has fixed contacts (126) and a movable electrical contact bridge (124).

7. The power switch (100) as recited in any preceding claim, wherein the controller (202) compares the collected data and stored data to determine if the collected data is within designated safety ranges, and wherein the controller (202) terminates the operation of the power switch if the collected data is not within the designated safety ranges.

8. A method (300) of monitoring the operation of an electrical control system of a power switch (100), the method including:
transmitting (306) real time collected data back from sensors (204) located internal to a housing (102) of a power switch controller (202) located internal to the housing of the power switch;
comparing (308), in real time, the collected data to data stored in the controller (202) to determine if the collected data is within the designated safety ranges;
wherein if the collected data is outside of the designated safety ranges, the controller (202) terminates the operation of the power switch;
wherein if the collected data is within the designated safety ranges, the controller (202) allows the operation of the power switch to continue.

9. The method (300) of monitoring the operation of an electrical control system of a power switch (100) as recited in claim 8, wherein the collected data is communicated via the communication bus (210) outside of the housing (102) of the power switch.

10. The method (300) of monitoring the operation of an electrical control system of a power switch (100) as recited in claim 8 or 9, wherein if the collected data is outside of the designated safety ranges, a coil current applied to an electrically conductive coil (132) of the power switch is stopped.

11. The method (300) of monitoring the operation of an electrical control system of a power switch (100) as recited in claim 8, 9 or 10, wherein the controller (202) continues to compare, in real time, the collected data to the stored data to determine if the collected data is outside of the designated safety ranges, wherein if the collected data is outside of the designated safety ranges, the controller (202) terminates the operation of the power switch (100).

12. The method (300) of monitoring the operation of an electrical control system of a power switch (100) as recited in any one of claims 8 to 11, wherein the controller (202) is a microcontroller.

13. The method of monitoring the operation of an electrical control system of a power switch as recited in any one of claims 8 to 12, wherein the controller (202) includes a memory.

14. The method (300) of monitoring the operation of an electrical control system of a power switch (100) as recited in any one of claims 8 to 13, wherein the power switch is a contactor.

15. The method (300) of monitoring the operation of an electrical control system of a power switch (100) as recited in claim 14, wherein the contactor has fixed contacts (126) and a movable electrical contact bridge (124), wherein if the collected data is outside of the designated safety ranges, a coil current applied to an electrically conductive coil (132) of the power switch is stopped to prevent the mating of the movable electrical contact bridge (124) with the fixed contacts (126).
